Europäisches Patentamt

European Patent Office

Office européen des brevets

(19)

(11) Numéro de publication: **0 165 832**
**B1**

(12) ## FASCICULE DE BREVET EUROPEEN

(45) Date de publication du fascicule du brevet:
**09.03.88**

(51) Int. Cl.⁴: **H 05 K 5/02**

(21) Numéro de dépôt: **85400862.0**

(22) Date de dépôt: **03.05.85**

(54) Obturateur porte-étiquette.

(30) Priorité: **09.05.84 FR 8407390**

(43) Date de publication de la demande:
**27.12.85 Bulletin 85/52**

(45) Mention de la délivrance du brevet:
**09.03.88 Bulletin 88/10**

(84) Etats contractants désignés:
**AT BE CH DE FR GB IT LI NL SE**

(56) Documents cités:
**DE - A - 1 465 423**
**FR - A - 2 527 893**
**US - A - 1 930 610**
**US - A - 3 864 511**

(73) Titulaire: **MERLIN GERIN, Rue Henri Tarze,**
**F-38050 Grenoble Cédex (FR)**

(72) Inventeur: **Chambron, Robert, Le Clos "La Fin du**
**Pêchet", F-73250 St. Pierre D'Albigny (FR)**
Inventeur: **Rebesco, Joseph, Impasse de la Villa**
**Romaine Arbin, F-73800 Montmelian (FR)**

(74) Mandataire: **Kern, Paul et al, Merlin Gerin Sce.**
**Brevets 20, rue Henri Tarze, F-38050 Grenoble Cédex**
**(FR)**

ACTORUM AG

## Description

L'invention est relative à un obturateur amovible susceptible d'obturer dans une première position une ouverture ménagée dans une face avant d'un coffret d'appareillage électrique, ladite ouverture donnant accès ou passage à la manette de commande d'un appareillage logé dans le coffret, après enlèvement de l'obturateur. Un tel obturateur est connu du US-A-3 864 511.

La face avant ou le plastron d'un coffret d'appareillage électrique, notamment de distribution terminale, comporte une ouverture de passage de la partie avant des appareils munie de la manette de commande. La largeur de cette ouverture correspond au nombre maximal d'appareils pouvant être logés dans le coffret, et il est courant d'obturer la partie de l'ouverture non occupée par un appareil électrique par une plaque obturatrice facilement amovible lors de l'adjonction d'un appareil additionnel. La plaque obturatrice ou obturateur est généralement clipsée sur les bords de l'ouverture, ses dimensions correspondant au module de l'appareillage. La présente invention part de la constatation que les obturateurs, enlevés pour la mise en place d'un appareil électrique, sont inutilisés et que leur configuration générale est voisine des étiquettes de repérage ou des porte-étiquettes livrés généralement avec ce type de coffret.

L'obturateur selon la présente invention est caractérisé en ce que ledit obturateur présente des moyens de fixation à ladite face avant dans une deuxième position de dégagement de ladite ouverture, l'obturateur dans ladite deuxième position étant agencé en porte-étiquette de repérage des circuits ou appareils.

L'obturateur est agencé pour occuper deux positions, l'une dans sa fonction d'obturateur et l'autre dans sa fonction de porte-étiquette. Selon un premier mode de mise en œuvre de l'invention, l'obturateur est constitué de deux parties reliées par une charnière, une partie fixe solidarisée au bord de l'ouverture, et une partie pivotante de recouvrement ou d'obturation de l'ouverture. L'obturateur constitue un véritable volet, qui en position abaissé ferme l'ouverture et en position relevée dégage l'ouverture. La partie mobile de l'obturateur pivote de 180° pour venir se plaquer contre la face avant du coffret en rendant visible l'arrière de l'obturateur. L'obturateur est en matière plastique moulée dont la partie fixe est agencée en pince chevauchant le bord de l'ouverture. Des ergots d'encliquetage verrouillent l'obturateur en position fermée et en position d'ouverture, la charnière étant constituée par une partie amincie de l'obturateur. Le volet obturateur est de préférence du type fractionnable en éléments d'une largeur correspondant au module de l'appareillage, de façon à dégager exactement la surface nécessaire à l'emplacement des appareils. Le porte-étiquette peut recevoir des étiquettes de dimensions multiples du module correspondant à l'appareillage repéré.

Selon une variante de réalisation de l'invention, l'obturateur est constitué de deux parties distinctes, une partie fixe à deux profilés enfichés sur les deux bords longitudinaux de l'ouverture, et une partie mobile en forme de plaquette. La plaquette peut être encliquetée sur les deux profilés dans une position de fermeture de l'ouverture ou, après dégagement, être encliquetée sur l'un des profilés pour constituer le porte-étiquette. Pour des raisons de simplicité, certains des éléments d'encliquetage de la plaquette sont agencés pour servir à l'encliquetage dans l'une et dans l'autre des positions, ou pour l'encliquetage en position horizontale ou verticale du porte-étiquette. L'obturateur présente toujours la même face, laquelle peut porter des éléments de fixation d'une étiquette ou être agencée pour servir d'étiquette après gravure ou tout autre mode d'impression adéquat. L'étiquette peut porter une prégravure du genre affichage digital permettant à l'usager de faire apparaître les symboles requis. Dans le cas d'une face avant en matière plastique les profilés de fixation des obturateurs viennent de moulage.

D'autres avantages et caractéristiques ressortiront plus clairement de la description qui va suivre des différents modes de mise en œuvre, donnés à titre d'exemples non limitatifs er représentés aux dessins annexés, dans lesquels:

la figure 1 est une vue schématique en élévation d'un coffret équipé d'un obturateur porte-étiquette selon l'invention;

les figures 2 et 3 sont des coupes respectivement selon les lignes II-Ii et III-III de la fig. 1;

la figure 4 est une vue en élévation d'un obturateur porte-étiquette, selon l'invention, pour un appareil à quatre pôles;

la figure 5 est une vue analogue à celle de la fig. 4, illustrant différentes positions des étiquettes;

la figure 6 est une vue schématique en perspective d'une face avant équipée d'obturateurs porte-étiquette, selon l'invention;

la figure 7 est une coupe suivant la ligne VII-VII de la fig. 6;

la figure 8 est une vue derrière de la plaquette obturatrice selon la fig. 6, la figure 8a étant une coupe suivant la ligne VIIIa-VIIIa de la fig. 8, à échelle agrandie;

la figure 9 est une vue schématique en élévation montrant différentes positions d'un obturateur porte-étiquette selon une autre variante de réalisation;

la figure 10 est une vue de derrière de la plaquette d'obturation selon la figure 9;

les figures 11 et 12 sont des coupes respectivement selon les lignes XI-XI et XII-XII de la fig. 10, à échelle agrandie;

la figure 13 est une coupe suivant la ligne XIII-XIII de la fig. 9, à échelle agrandie;

la figure 14 est une vue analogue à celle de la fig. 3, d'un coffret moulé avec une représentation en perspective d'un obturateur et une vue agrandie de la fixation;

la figure 15 est une vue de face de l'obturateur avec un agrandissement de la prégravure;

la figure 16 représente les symboles résultant de la prégravure.

Sur les figures, un coffret 10 de logement d'appareillage électrique, notamment d'appareillage modulaire du type commercialement dénommé MULTI 9, présente sur son fond arrière 12 un profil type chapeau 14 d'encliquetage des appareils 16. Les appareils 16 sont du type à boîtier moulé miniature ayant une partie frontale 18 équipée d'une manette de commande 20 faisant saillie par une ouverture 22 ménagée sur la face avant 24 du coffret 10. L'ouverture rectangulaire 22 ménagée en usine sur la face avant 24 s'étend sur la quasi-totalité de la largeur du coffret 10, sa longueur correspondant au nombre de modules, en l'occurrence quatre, susceptibles d'être logés dans le coffret 10. De tels coffrets sont bien connus et ils sont généralement livrés avec une plaque obturant l'ouverture 22. Cette plaque ou obturateur est en matière plastique, fractionnable en éléments d'une largeur correspondant au module de l'appareillage. Il est ainsi possible de dégager une partie de l'ouverture 22 pour recevoir les appareils 16 correspondants, l'autre partie de l'ouverture 22 non utilisée étant recouverte par l'obturateur.

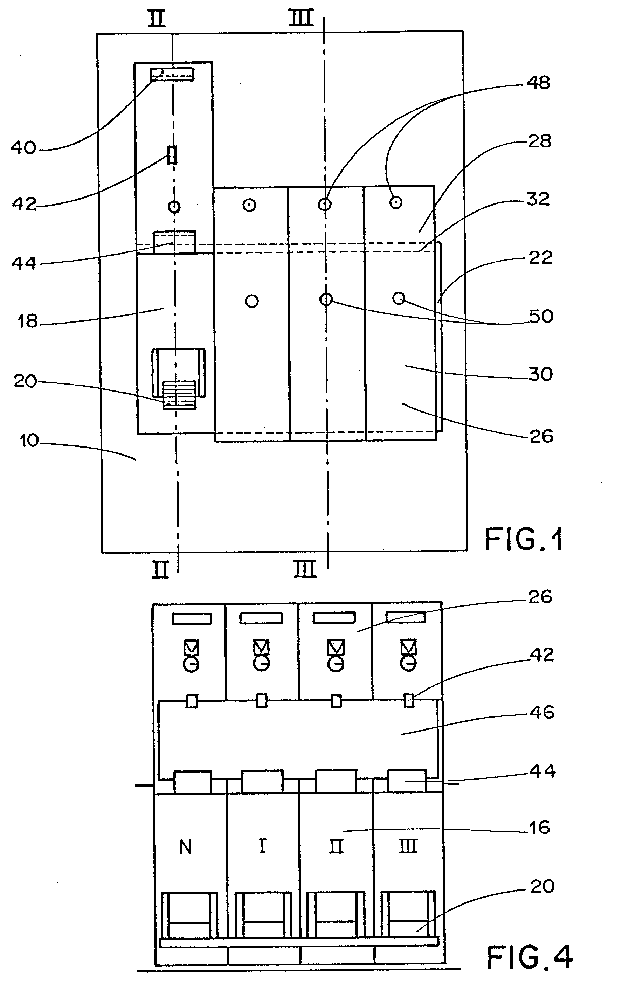

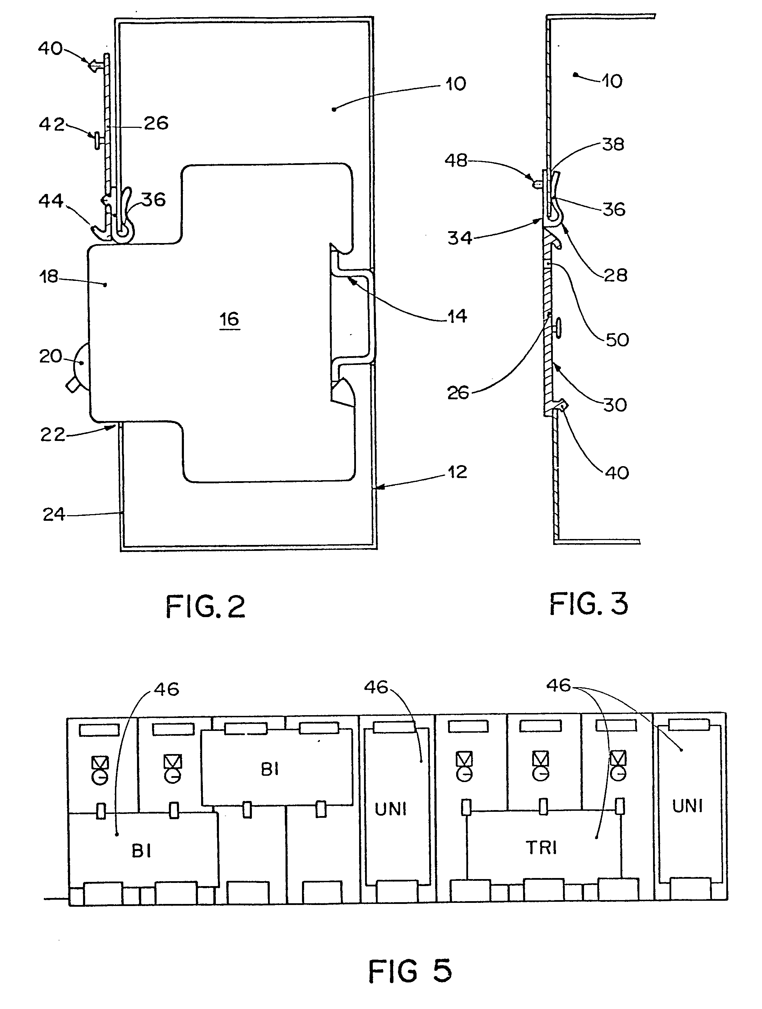

Selon la présente invention, un obturateur 26 est agencé en forme de volet constitué d'une partie fixe 28 et d'une partie mobile 30 reliées par une charnière 32. L'obturateur 26 est en matière plastique moulée, la charnière 32 étant constituée par une partie amincie conférant à l'obturateur une souplesse suffisante à un pliage. La partie fixe 28 présente deux branches 34, 36 formant une pince du genre épingle è cheveux enfichée sur le bord 38 de l'ouverture 22. La charnière 32 s'étend le long du bord 38 pour permettre un pivotement de la partie mobile 30, qui peut occuper, soit la position d'obturation de l'ouverture 22, représentée à la figure 3, soit la position relevée illustrée à la figure 2. Le coffret 10 selon la figure 1 contient un seul module, en l'occurrence un disjoncteur miniature unipolaire 16 et une partie de l'obturateur 26, à l'emplacement de l'appareil 16 est relevée et plaquée contre la face avant 24. La partie restante de l'ouverture 22 est coiffée par l'obturateur 26. La partie mobile 30 porte sur sa face externe en position relevée trois ergots 40, 42, 44, à tête évasée permettant une fixation par clipsage d'une étiquette 46. L'ergot 40, disposé à l'extrémité de l'obturateur 26, constitue un ergot d'encliquetage sur le bord inférieur de l'ouverture 22 en position rabattue de la partie mobile 30 (fig. 3). D'une manière analogue, la partie mobile 30 est retenue en position relevée par un encliquetage constitué par un ergot 48 porté par la partie fixe 28 qui s'encliquète dans un orifice 50, ménagé dans la partie mobile 30. Il est clair que la partie fixe 28 de l'obturateur pourrait être enfichée sur le bord inférieur de l'ouverture 22, et que le verrouillage en position rabattue pourrait être réalisé d'une manière différente. L'ergot 42 de la face porte-étiquette est disposé au centre entre les ergots 40, 44, pour permettre différentes fixations des étiquettes de la manière décrite ci-dessous.

La figure 4 montre un obturateur porte-étiquette pour un appareil modulaire à quatre pôles, l'étiquette 46 d'une dimension correspondant sensiblement à la largeur de l'appareil 16 étant encliquetée sue les ergots inférieurs 42, 44 du porte-étiquette. La partie supérieure délimitée par les ergots 40, 42 est inutilisée ou porte un repère commun, en l'occurrence un logotype moulé dans l'obturateur. L'étiquette 46 porte bien entendu les éléments de repérage de l'appareil ou du circuit protégé, cette étiquette étant soit une plaquette en aluminium ou en matière plastique, soit de toute autre constitution.

La figure 5 illustre différents positionnements d'étiquettes 46 pour des appareils bi-polaires BI, unipolaires UNI ou tripolaires TRI. Les étiquettes 46 sont fixées soit horizontalement sur la partie inférieure ou supérieure du porte-étiquette, soit verticalement avantageusement sur toute la hauteur du porte-étiquette. Dans ce dernier cas l'ergot 42 est supprimé.

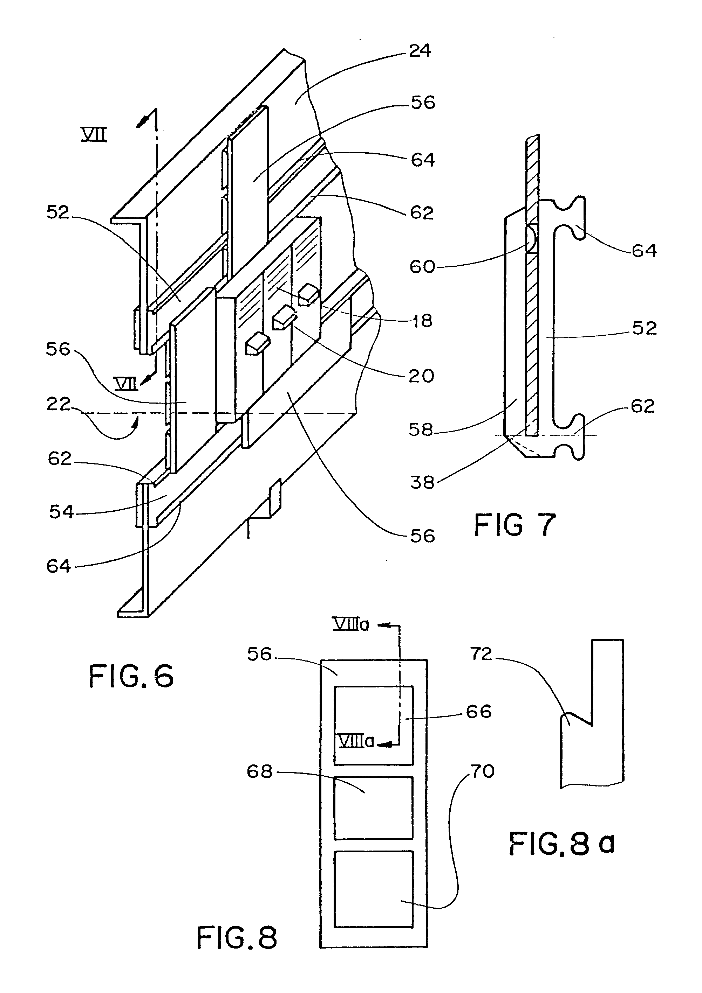

Les figures suivantes illustrent des variantes de réalisation, les mêmes numéros de repère désignant des pièces analogues ou identiques à celles des figures 1 à 5. L'obturateur est constitué de deux profilés 52, 54, fixés sur les deux bords longitudinaux 38 de l'ouverture 22 et d'une partie amovible 56 susceptible d'obturer l'ouverture 22. La partie amovible 56 peut être une plaque fractionnable ou une série de plaquettes d'une largeur correspondant au module des appareils 16. Les profilés 52, 54 sont identiques et portent chacun à l'arrière une languette 58 formant avec l'avant une pince de fixation sur le bord 38. Le verrouillage du profilé 52 peut être réalisé par un bossage 60 s'encliquetant dans un orifice ménagé dans la face avant 24. Le profilé 52 porte à l'avant deux nervures 62, 64 à tête évasée permettant l'encliquetage de la partie amovible en forme de plaquetage 56. En se référant plus particulièrement à la figure 8, on voit que la plaquette 56 porte sur sa face arrière trois dés 66, 68, 70 à bords 72 évasés d'encliquetage. L'écartement entre les nervures d'encliquetage 62, 64 des profilés 52, 54 correspond à la largeur du côté des dés 66, 68, 70 pour permettre l'encliquetage de l'un quelconque de ces dés sur le profilé 52, 54. L'écartement entre les nervures 62 des profilés 52, 54 le long des bords 38 de l'ouverture 22 correspond à l'écartement entre les bords externes des dés 66, 70 pour permettre un encliquetage de la plaquette 56 sur l'ouverture 22. Sur la figure 6 sont représentées trois positions d'encliquetage de l'obturateur 56, respectivement en position d'obturation de l'ouverture 22, en position verticale au-dessus de la face avant 18 des appareils 16 et en position horizontale en-dessous de cette face avant 18. Il est clair que d'autres dispositions sont possibles, notamment une position verticale en-dessous de la face avant et analogues.

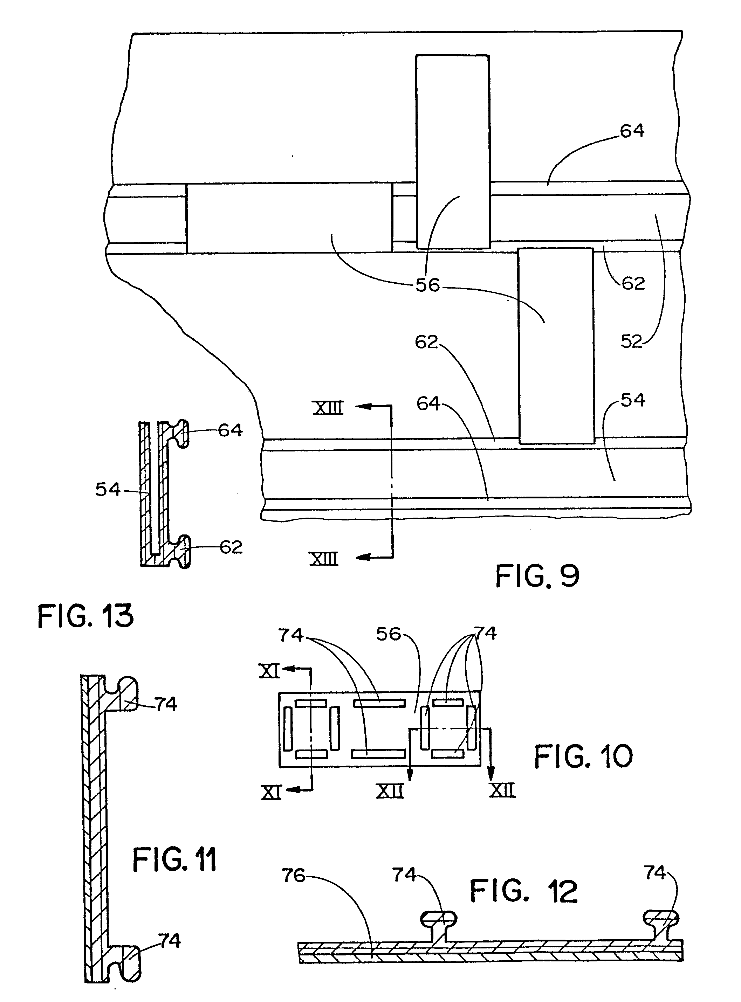

Dans cette disposition, la même face avant de l'obturateur 56 est toujours visible, ceffe face pouvant recevoir une étiquette, par exemple autocollante, ou tout autre moyen de repérage. Cette face peut évidemment comporter des ergots de clipsage du type décrit en référence aux figures 1 à 5 pour la fixation d'étiquettes indépendantes. La face avant peut également être à double couche décrite ci-dessous en référence à la figure 12.

Les figures 9 à 13 illustrent une variante de réalisation très voisine de celle des figures 6 à 8, la différence portant essentiellement sur la plaquette d'obturation 56 et plus particulièrement sur les moyens d'encliquetage constitué par des nervures à tête évasée 74. En se référant plus particulièrement à la figure 10, on voit que ces nervures sont disposées en carré dans les parties d'extrémité de la plaquette obturateur 56 formant un ensemble comparable aux dés 66, 70, tandis que la partie médiane de la plaquette 56 comporte uniquement deux nervures 74 parallèles aux bords longitudinaux. La face avant de l'obturateur 56 porte une couche 76 d'une couleur différente susceptible d'être enlevée par gravure pour faire apparaître les repères constituant l'étiquette. Il est évident que les plaquettes 56 peuvent être assemblées à l'origine en une plaque unique fractionnable et que leur mode de fixation peut être différent.

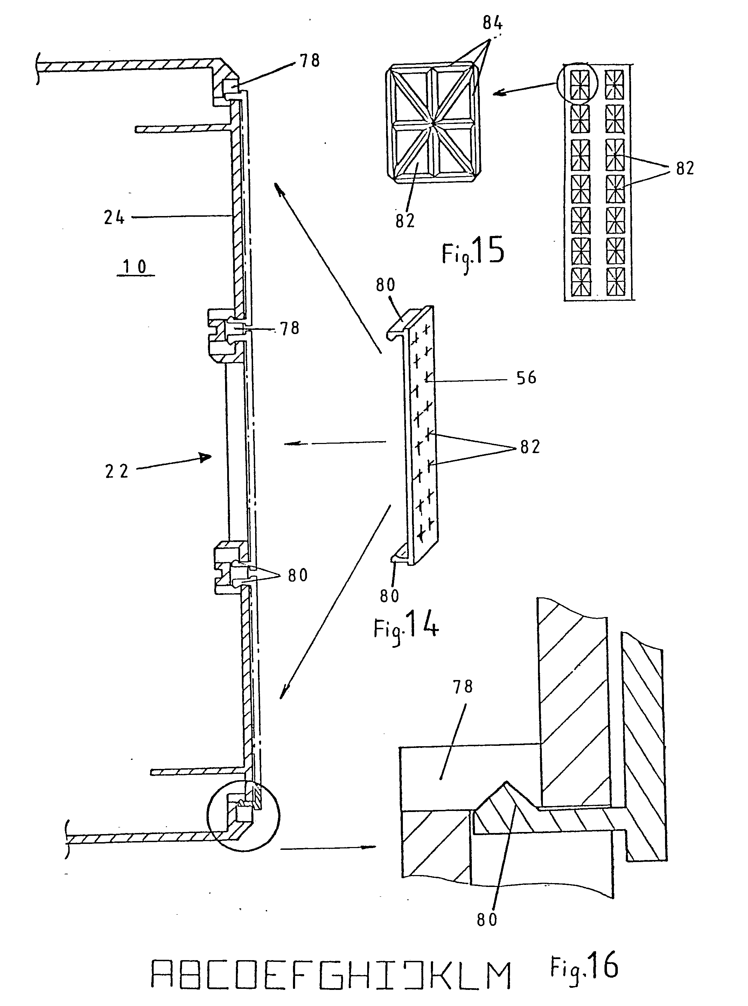

Les figures 14 à 16 illustrent une autre variante particulièrement adaptée à un plastron ou coffret 10 en matière moulée. La face avant 24 présente des profilés 78 d'encliquetage de crochets 80 solidaires de l'obturateur 56. La disposition des profilés 78 permet une fixation de l'obturateur 56 sur l'ouverture 22 ou à côté de l'ouverture comme étiquette. La face avant de l'obturateur porte des prégravures 82, dont la figure 15 représente un exemple de réalisation pour l'affichage de chiffres et de lettres. Chaque prégravure 82 comporte des segments de droit 84 formant un rectangle avec ses diagonales et ses médiatrices. La prégravure consiste en une rainure de faible profondeur, une nervure ou tout autre repère guidant l'opérateur pour tracer le caractère approprié. L'inscription est effectué par grattage, par exemple du fond de la rainure, pour faire apparaître une sous-couche d'une couleur ou d'un aspect différent ou éventuellement par un apport de couleur ou d'ancre. Ce système d'inscription à batonnets est utilisable pour des chiffres et lettres, dont certains sont représentés à titre d'exemple à la figure 16, d'autres repères pouvant être prévus. Un affichage de ce genre convient également pour les inscriptions sur les étiquettes décrites ci-dessus.

## Revendications

1. Obturateur (30) amovible susceptible d'obturer dans une première position une ouverture (22) ménagée dans une face avant (24) d'un coffret (10) d'appareillage électrique (16), ladite ouverture donnant accès ou passage, après enlèvement de l'obturateur, à la manette (20) de commande d'un appareillage logé dans le coffret, caractérisé en ce que ledit obturateur (30) présente des moyens (48, 50; 62, 64, 80) de fixation à ladite face avant (24) dans une deuxième position de dégagement de ladite ouverture (22), l'obturateur dans ladite deuxième position étant agencé en porte-étiquette de repérage des circuits ou appareils (16).

2. Obturateur selon la revendication 1, caractérisé en ce qu'il comporte une partie fixe (28) fixée en permanence à l'un (38) des bords de l'ouverture (22) et une partie mobile (26) articulée sur la partie fixe et susceptible d'occuper une position abaissée d'obturation de l'ouverture (22) et une position relevée pivotée de dégagement de l'ouverture, dans laquelle l'obturateur est plaqué contre la face avant (24) du coffret et présente sa face libre agencée en porte-étiquette.

3. Obturateur selon la revendication 2, caractérisé en ce que les moyens de fixation comportent des moyens d'encliquetage (40, 48, 50) dans les deux positions d'obturation et de porte-etiquette.

4. Obturateur selon la revendication 2 ou 3, en un matériau plastique, caractérisé en ce que la partie fixe (28) comprend une pince à deux branches (34, 36) engagée à cheveauchement sur le bord (38) de l'ouverture (22), la partie mobile (26) étant solidarisée à la partie fixe par une ligne amincie formant une charnière (32) adjacente et parallèle audit bord.

5. Obturateur selon la revendication 4, caractérisé en ce que la partie mobile (26) porte à son extrémité opposée à la charnière (32) un picot (40) susceptible de s'encliqueter sur le bord opposé de l'ouverture (22) pour maintenir l'obturateur (30) en position d'obturation et de constituer un picot d'accrochage de l'étiquette (46) dans la position relevée de l'obturateur.

6. Obturateur selon la revendication 2, 3, 4 ou 5, caractérisé en ce que la partie fixe (28) porte un moyen (48) d'encliquetage de la partie mobile (26) en position relevée.

7. Obturateur selon la revendication 1, caractérisé en ce que les moyens de fixation de l'obturation sont des moyens (62, 64) d'encliquetage sur deux profilés (52, 54) fixés respectivement aux bords (38) opposés de l'ouverture (22) et que l'obturateur comporte une partie amovible (56) susceptible d'être encliquetée sélectivement sur lesdits profilés (52, 54) dans la première position d'obturation de l'ouverture (22) et dans la deuxième position de dégagement dans laquelle l'obturateur est agencé en porte-etiquette.

8. Obturateur selon la revendication 7, caractérisé en ce que la partie amovible (56) en forme de plaquette présente au moins deux dés carrés (66, 68, 70, 74) de clipsage identiques, de forme conjuguée à celle des moyens (62, 64) pour permettre un clique-tage de la plaquette en différents positions, porte-étiquette, notamment verticale et horizontale.

9. Obturateur selon la revendication 7 ou 8, caractérisé en ce que chacun desdits profilés (52, 54) est en matière plastique et comporte à l'arrière une languette (58) formant avec l'avant une pince de fixation à deux branches engagées à chevauchement sur le bord (38) de l'ouverture (22) et que chacun desdits profilés comporte à l'avant deux nervures (62, 64) espacées de clipsage.

10. Obturateur selon la revendication 1, pour une face avant (24) en matière moulée, caractérisé en ce que les moyens de fixation comportent des crochets (80) d'encliquetage coopérant avec des profilés (78) d'encliquetage venant de moulage avec la face avant du coffret.

11. Obturateur selon l'une quelconque des revendications précédentes, caractérisé en ce qu'il comporte une couche (76) bi-matière permettant une gravure constituant ladite étiquette.

12. Obturateur selon l'une quelconque des revendications précédentes, caractérisé en ce qu'il comporte un prémarquage (82) de symboles facilitant l'inscription sur l'étiquette.

13. Obturateur selon la revendication 12, caractérisé en ce que le prémarquage est constitué de segments de droite (84) s'étendant suivant les côtés, les diagonales et les médiatrices d'un rectangle pour la constitution de chiffres et de lettres.

14. Obturateur selon la revendication 12 ou 13, caractérisé en ce que le prémarquage consiste en une rainure (84) de guidage de l'outil de marquage.

## Patentansprüche

1. Abnehmbare Abdeckkappe (30), die in einer ersten Lage eine Öffnung (22) bedecken kann, welche in der Vorderseite (24) eines Gehäuses (10) elektrischer Geräte (16) angeordnet ist, wobei diese Öffnung nach Abnahme der Abdeckkappe einem Steuerhebel (20) elektrischer in dem Gehäuse untergebrachter Geräte Zugang oder Durchgang bietet, dadurch gekennzeichnet, dass die genannte Abdeckkappe (30) Mittel (48, 50; 62, 64, 80) aufweist zur Befestigung an der genannten Vorderseite (24) in einer zweiten unbedeckten Lage der genannten Öffnung (22), wobei die Abdeckkappe in der genannten zweiten Lage als Etiketten-Träger zur Markierung der Schaltungen oder Geräte (16) ausgebildet ist.

2. Abdeckkappe gemäss Anspruch 1, dadurch gekennzeichnet, dass sie ein feststehendes Teil (28) aufweist, das dauernd an einem (38) der Ränder der Öffnung (22) befestigt ist, und dass sie ein bewegliches Teil (26) aufweist, das auf dem feststehenden Teil beweglich gelagert ist und eine gesenkte Lage zum Schliessen der Öffnung (22) und eine hochgeschwenkte Lage zur Öffnungsbefreiung einnehmen kann, in der die Abdeckkappe gegen die Vorderseite (24) des Gehäuses gedrückt wird und ihre freie Fläche als Etiketten-Träger ausgebildet ist.

3. Abdeckkappe gemäss Anspruch 2, dadurch gekennzeichnet, dass die Befestigungsmittel Einrastmittel (40, 48, 50) in den beiden verschlossenen und Etikett-tragenden Lagen aufweisen.

4. Abdeckkappe gemäss Anspruch 2 oder 3, aus Plastik-Material, dadurch gekennzeichnet, dass das feststehende Teil (28) eine Klemme mit zwei Schenkeln (34, 36) aufweist, die den Rand (38) der Öffnung (22) überlappt, wobei das bewegliche Teil (26) mit dem feststehenden Teil durch eine verjüngte Linie verbunden ist, die ein zu dem genannten Rand anliegendes und paralleles Gelenk (32) bildet.

5. Abdeckkappe gemäss Anspruch 4, dadurch gekennzeichnet, dass das bewegliche Teil (26) an seinem dem Gelenk entgegengesetzten Ende (32) einen Zapfen (40) trägt, der auf dem gegenüber liegenden Rand der Öffnung (22) einrasten kann, um die Abdeckkappe (30) in der verschlossenen Lage zu halten und um einen Aufhängezapfen für das Etikett in der gehobenen Lage der Abdeckkappe zu bilden.

6. Abdeckkappe gemäss Anspruch 2, 3, 4 oder 5, dadurch gekennzeichnet, dass das feststehende Teil (28) ein Einrastmittel (48) des beweglichen Teiles (26) in der gehobenen Lage trägt.

7. Abdeckkappe gemäss Anspruch 1, dadurch gekennzeichnet, dass die Befestigungsmittel der Abdeckkappe Einrastmittel (62, 64) auf zwei Profilen (52, 54) sind, die bzw. an den entgegengesetzten Rändern (38) der Öffnung (22) befestigt sind, und dass die Abdeckkappe ein abnehmbares Teil (56) aufweist, das wahlweise auf den genannten Profilen (52, 54) einrasten kann, in einer ersten verschlossenen Lage der Öffnung (22) und in einer zweiten befreiten Lage, in der die Abdeckkappe als Etiketten-Träger ausgebildet ist.

8. Abdeckkappe gemäss Anspruch 7, dadurch gekennzeichnet, dass das abnehmbare plattenförmige Teil (56) wenigstens zwei viereckige, identische Aufklemmwürfel (66, 68, 70; 74) aufweist, von einer den Einrastmitteln (62, 64) der genannten Profile (52, 54) entsprechenden Form, um ein Einrasten der Platte in verschiedenen Lagen als Etikett-Träger, insbesondere senkrecht und waagerecht, zu erlauben.

9. Abdeckkappe gemäss Anspruch 7 oder 8, dadurch gekennzeichnet, dass jedes der genannten Profile (52, 54) aus Plastik-Material besteht und hinten eine Zunge (58) aufweist, die mit dem Vorderteil eine Befestigungsklemme mit zwei Schenkeln bildet, die den Rand (38) der Öffnung (22) überdeckt, und dass jedes der genannten Profile vorne zwei auseinanderliegende Einrast-Rippen (62, 64) aufweist.

10. Abdeckkappe gemäss Anspruch 1, für eine Vorderseite (24) aus Gussmaterial, dadurch gekennzeichnet, dass die Befestigungsmittel Einrast-Haken (80) aufweisen, die mit Einrast-Profilen (78) zusammenarbeiten, die mit der Vorderseite des Gehäuses gegossen sind.

11. Abdeckkappe gemäss irgendeinem der vorhergehenden Ansprüche, dadurch gekennzeichnet, dass sie eine aus zwei Werkstoffen bestehende Oberflächenschicht (76) aufweist, die eine Gravierung zulässt, welche das genannte Etikett bildet.

12. Abdeckkappe gemäss irgendeinem der vorhergehenden Ansprüche, dadurch gekennzeichnet, dass sie eine Vor-Markierung (82) der Zeichen aufweist, was die Beschriftung des Etiketts erleichtert.

13. Abdeckkappe gemäss Anspruch 12, dadurch gekennzeichnet, dass die Vor-Markierung aus Streckenabschnitten (84) gebildet ist, die sich gemäss den Seiten, Diagonalen und Mittellinien eines Rechtecks erstrecken zur Bildung der Zahlen und Buchstaben.

14. Abdeckkappe gemäss Anspruch 12 oder 13, dadurch gekennzeichnet, dass die Vor-Markierung aus einer Führungsrille (84) des Markierungs-Werkzeuges besteht.

## Claims

1. Removable cover (30) which can seal in a first position an aperture (22) situated in a front face (24) of an enclosure (10) of switchgear (16) said aperture permitting after removal of the cover the passage of a control handle (20) of switchgear lodged in the enclosure, characterized in that said cover (30) comprises fastening means (48, 50; 62, 64, 80) to said front face (24) in a second free position of said aperture (22), the cover constituting in said second position a label bearer for referencing circuits or apparatus (16).

2. Cover acording to claim 1, characterized in that it comprises a stationary part (28) fastened permanently to one (38) of the edges of the aperture (22) and a movable part (26) linked on the stationary part which can come into a lowered position sealing the aperture (22) and a pivoted raised position liberating the aperture, in which position the cover is urged against the front face (24) of the enclosure and its free face is arranged as label bearer.

3. Cover according to claim 2, characterized in that the fastening means comprise ratching means (40, 48, 50) in the two positions of covering and label bearing.

4. Cover according to claim 2 or 3, made of plastic material, characterized in that stationary part (28) comprises a grip with two legs (34, 36) overlapping the edge (38) of the aperture (22), the movable part (26) being connected with the stationary part by means of a thin line constituting a joint (32) which is adjacent and parallel to said edge.

5. Cover according to claim 4, characterized in that the movable part bears on its end opposite to the joint (32) a pin (40) which can ratch on the opposite edge of aperture (22) in order to maintain the cover (30) in the sealing position and to constitute a hooking-up pin of the label (46) in the raised position of the cover.

6. Cover according to claim 2, 3, 4 or 5, characterized in that the stationary part (28) bears a ratching means (48) of the movable part (26) in raised position.

7. Cover according to claim 1, characterized in that the fastening means of the cover are ratching means (62, 64) on two sections (52, 54) fixed respectively to the opposite edges (38) of the aperture (22), and that the cover comprises a removable part (56) which can selectively be ratched on said sections (52, 54) in the first position sealing the aperture (22) and in the second raised position in which the cover constitutes a label bearer.

8. Cover according to claim 7, characterized in that the removable part (56) in form of a plate comprises at least two identical square clipping dice (66, 68, 70, 74), of a form corresponding to that of the ratching means of said section (52, 54) in order to authorize an engagement in different positions, label-bearing, especially vertical and horizontal.

9. Cover according to claim 7 or 8, characterized in that each of said sections (52, 54) is made of plastic material and comprises at the back part a tongue (58) constituting with the front part a fixing clamp with two legs engaged with overlapping on the edge (38) of the aperture (22), and that each of said sections comprises at the front part two spaced apart clipping ribs (62, 64).

10. Cover according to claim 1, for a front face (24) of moulded material, characterized in that the fastening means comprises ratching hooks (80) cooperating with ratching sections (78) being moulded with the front face of the enclosure.

11. Cover according to anyone of the preceding claims, characterized in that it comprises a bi-material coat (76) authorizing an engraving constituting said label.

12. Cover according to anyone of the preceding claims, characterized in that it comprises a pre-marking (82) of symbols facilitating the inscription on the label.

13. Cover according to claim 12, characterized in that the pre-marking is constituted of right segments (84) extending according the sides, diagonal lines and mediating lines of a rectangle for the constitution of figures and letters.

14. Cover according to claim 12 or 13, characterized in that the pre-marking consists in a guiding groove (84) of the marking tool.

0 165 832

FIG.1

FIG.4

0 165 832

FIG. 2

FIG. 3

FIG 5

FIG 7

FIG. 6

FIG. 8

FIG. 8 a

FIG. 9

FIG. 13

FIG. 11

FIG. 10

FIG. 12

84

82

82

Fig.15

80

10

24

78

78

56

82

22

80

80

Fig.14

78

80

ABCDEFGHIJKLM  Fig.16